# EUROPEAN PATENT SPECIFICATION

(11) **EP 4 510 453 B1**
(45) Date of publication and mention of the grant of the patent: **25.03.2026**
(21) Application number: 23206692.8
(22) Date of filing: 30.10.2023
(51) Int. Cl.: H03K 17/13, H02M 1/00, H03K 17/16

(54) **SWITCH TRIGGER FOR SUPPRESSING INRUSH CURRENT**
SCHALTERAUSLÖSER ZUR UNTERDRÜCKUNG VON EINSCHALTSTROM
DÉCLENCHEUR DE COMMUTATEUR POUR SUPPRIMER UN COURANT D'APPEL

(30) Priority: 18.08.2023 CN 202311044893
(43) Date of publication of application: 19.02.2025
(73) Proprietor: DELTA ELECTRONICS, INC., Taoyuan City 333 (TW)
(72) Inventor: Ke, Ming-Yang, Taoyuan City 333 (TW)
(74) Representative: Uexküll & Stolberg

(56) References cited:
- WO-A1-2021/026519
- US-A1- 2019 007 040
- US-A1- 2020 365 346

## Description

### FIELD OF THE INVENTION

The present disclosure relates to a switch trigger, and more particularly to a switch trigger for suppressing an inrush current.

### BACKGROUND OF THE INVENTION

A conventional switch control method may suppress inrush current by soft start of switches. However, since a duration for turning on the switch increases, the switch must bear more heat losses, which not only reduces an efficiency but also makes the switch more susceptible to damage. In addition, as the duration for turning on the switch increases, a duration for turning off the switch also increases. Therefore, the longer duration for turning off the switch may cause the switch unable to be turned off immediately for implementing protection.

WO 2021/026519 A1 relates to a method of operating a circuit having a capacitor and a load that are connectable to, and disconnectable from, a voltage source by an electronically controllable switch, the method includes charging the capacitor by raising a voltage across the capacitor from an initial voltage value and at a constant rate by controlling the switch to supply current to the capacitor at a constant current supply rate that is selected to avoid damage to the switch, and then operating the switch to supply current from the voltage source to the capacitor when the voltage across the capacitor reaches the voltage source's voltage.

Therefore, there is a need of providing a switch trigger in order to overcome the drawbacks of the conventional technologies.

### SUMMARY OF THE INVENTION

The present disclosure provides a switch trigger which reduces a voltage variation while turning on a switch by precharge, thereby suppressing an inrush current. Consequently, the problems like efficiency reduction, switch damage, and an inability to turn off the switch immediately while triggering the protection, which are caused by the increased duration for switching the switch in conventional approach, are avoided. Moreover, in the present disclosure, the switch trigger is able to realize zero-voltage switching and has a function of short circuit protection.

In accordance with an aspect of the present disclosure, a switch trigger according to claim 1 is provided. Further preferred embodiments are defined in the dependent claims.

### BRIEF DESCRIPTION OF THE DRAWINGS

FIG. 1 is a schematic circuit diagram illustrating a switch trigger according to a first embodiment of the present disclosure;
FIG. 2 is a schematic circuit diagram illustrating a switch trigger according to a second embodiment of the present disclosure;
FIG. 3A and FIG. 3B exemplify the key voltage and current waveforms of the switch trigger of FIG. 1 while realizing the inrush current suppression;
FIG. 4A and FIG. 4B exemplify the key voltage and current waveforms of the switch trigger of FIG. 1 while advancing the turn-on timing of the first switch for corresponding the operation of the back-stage converter; and
FIG. 5A and FIG. 5B exemplify the key voltage and current waveforms of the switch trigger of FIG. 1 while implementing the short-circuit protection for the short circuit occurring at the output.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

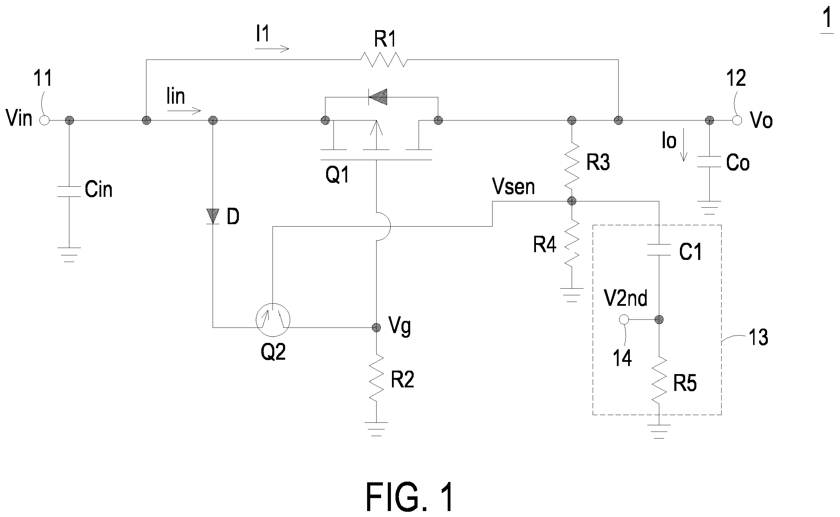

FIG. 1 is a schematic circuit diagram illustrating a switch trigger according to a first embodiment of the present disclosure. As shown in FIG. 1, the switch trigger 1 includes an input terminal 11, an output terminal 12, a first switch Q1, a bypass resistor R1, an output capacitor Co, a diode D, a second switch Q2, a discharging resistor R2, a first divider resistor R3, a second divider resistor R4, an input capacitor Cin, and a back-stage detection circuit 13. The first divider resistor R3 and the second divider resistor R4 form a voltage divider.

Structurally, the input terminal 11 is configured to receive an input voltage Vin, and the output terminal 12 is configured to provide an output voltage Vo. First and second terminals of the first switch Q1 are electrically connected to the input terminal 11 and the output terminal 12, respectively. Two terminals of the bypass resistor R1 are electrically connected to the input terminal 11 and the output terminal 12, respectively. Two terminals of the output capacitor Co are electrically connected to the output terminal 12 and a ground terminal, respectively. An anode of diode D is electrically connected to the input terminal 11, and the diode D is configured to prevent current backflow. First and second terminals of the second switch Q2 are electrically connected to a cathode of the diode D and a third terminal of the first switch Q1, respectively. Two terminals of the discharging resistor R2 are electrically connected to the third terminal of the first switch Q1 and the ground terminal, respectively. The first divider resistor R3 and the second divider resistor R4 are electrically connected in series between the output terminal 12 and the ground terminal. The first divider resistor R3 and the second divider resistor R4 are respectively coupled to the output terminal 12 and the ground terminal, and a connection node between the first divider resistor R3 and the second divider resistor R4 is electrically connected to a third terminal of the second switch Q2. Two terminals of the input capacitor Cin are respectively and electrically connected to the input terminal 11 and the ground terminal, and the input capacitor is configured for decoupling.

In operation, when initially power up, the first switch Q1 turns off, and the input voltage Vin charges the output capacitor Co through the bypass resistor R1 to gradually increase the output voltage Vo at the output terminal 12. At the same time, the second switch Q2 turns on so that the input voltage Vin builds up a voltage Vg across the discharging resistor R2. Afterwards, the first divider resistor R3 and the second divider resistor R4 divide the output voltage Vo to generate the voltage Vsen. When the voltage Vsen increases to a threshold sufficient to turn off the second switch Q2, the voltage Vg is discharged to the ground terminal through the discharging resistor R2, which causes the first switch Q1 to turn on. As the first switch Q1 turns on, the input voltage Vin is transmitted to the output terminal 12 to serve as the output voltage Vo.

It is noted that the voltage at the output terminal 12 has already been increased by charging the output capacitor Co through the bypass resistor R1. Therefore, when the first switch Q1 turns on, a voltage difference between the input terminal 11 and the output terminal 12 has been reduced already, and thus the inrush current caused by a large voltage difference is prevented. Further, as the voltage at the output terminal 12 gradually increases, a voltage at the second terminal of the first switch Q1 also increases gradually. When the first switch Q1 turns on, a voltage difference between the first and second terminals of first switch Q1 has been reduced already. Accordingly, the inrush current is suppressed, and a body diode of the switch Q1 is prevented from being damaged by an induced electromotive force generated due to Faraday's law of electromagnetic induction.

The switch trigger 1 further includes a back-stage detection circuit 13 electrically connected to the voltage divider. The back-stage detection circuit 13 is configured to provide a back-stage voltage V2nd to the voltage Vsen for adjusting a duration for turning on the first switch Q1. The back-stage detection circuit 13 includes a detection capacitor C1, a detection resistor R5, and a detection terminal 14. Two terminals of the detection capacitor C1 are electrically connected to the third terminal of the second switch Q2 and the detection terminal 14, respectively. Two terminals of the detection resistor R5 are electrically connected to the detection terminal 14 and the ground terminal, respectively. The detection terminal 14 is configured to detect an output voltage of a back-stage converter. For example, when the output terminal 12 is electrically connected to the back-stage converter (not shown), the back-stage converter converts the output voltage Vo provided by the switch trigger 1 at the output terminal 12 into the back-stage voltage V2nd. The detection terminal 14 is electrically connected to the back-stage voltage V2nd to detect the output voltage of the back-stage converter. The back-stage voltage V2nd causes an instant voltage across the detection capacitor C1 and meanwhile changes the voltage Vsen. As a result, a turn-off timing of the second switch Q2 is advanced, which advances a turn-on timing of the first switch Q1.

In multi-level power conversion systems, the switch trigger may be disposed in a first-stage power protector to prevent the inrush current when the power supply is powering up. In order to expedite a power-up process of the entire system, as soon as the output voltage Vo reaches to a reference voltage (e.g., 80% or 90% of the input voltage Vin), the back-stage converter begins to draw the output voltage Vo to perform voltage conversion. Therefore, it is necessary to advance the turn-on timing of the first switch Q1 to provide the enough output voltage Vo for the back-stage converter to operate normally.

In the first embodiment, the first switch Q1 may be a P-type MOSFET (metal-oxide-semiconductor field effect transistor), and the first, second and third terminals of the first switch Q1 are a source, drain and gate, respectively. The second switch Q2 may be a P-type BJT (bipolar junction transistor), and the first, second and third terminals of the second switch Q2 are an emitter, collector and base, respectively.

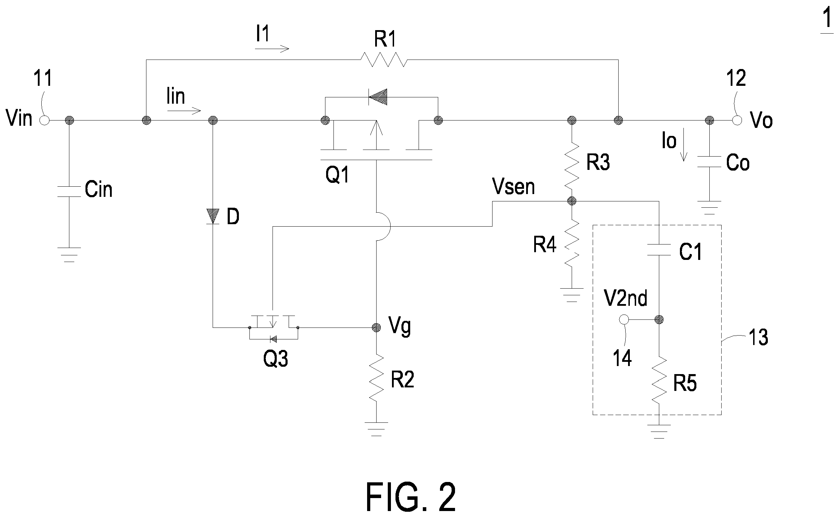

FIG. 2 is a schematic circuit diagram illustrating a switch trigger according to a second embodiment of the present disclosure. In FIG. 2, a second switch Q3 replaces the second switch Q2 of FIG. 1. The second switch Q3 is a P-type MOSFET, and first, second and third terminals of the second switch Q3 are a source, a drain and a gate, respectively.

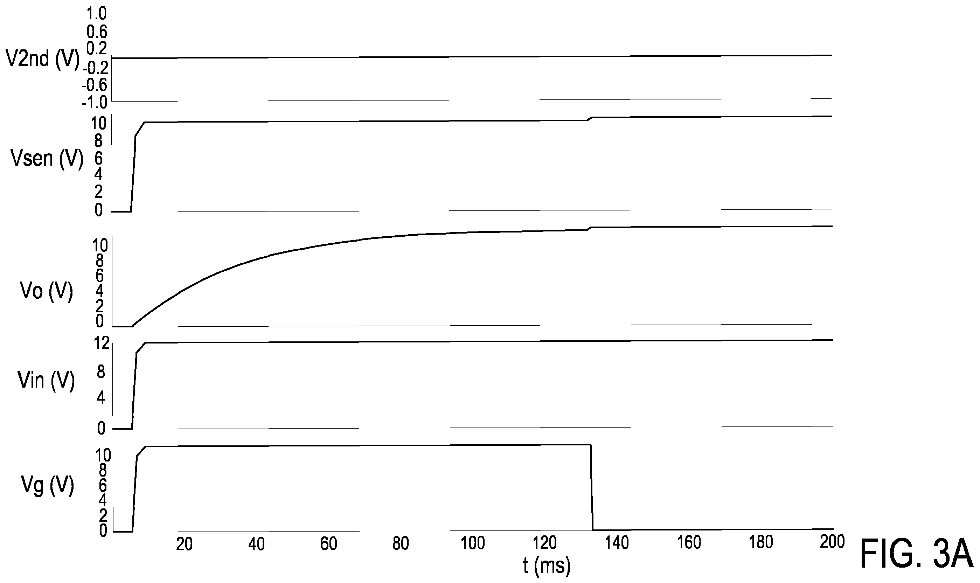

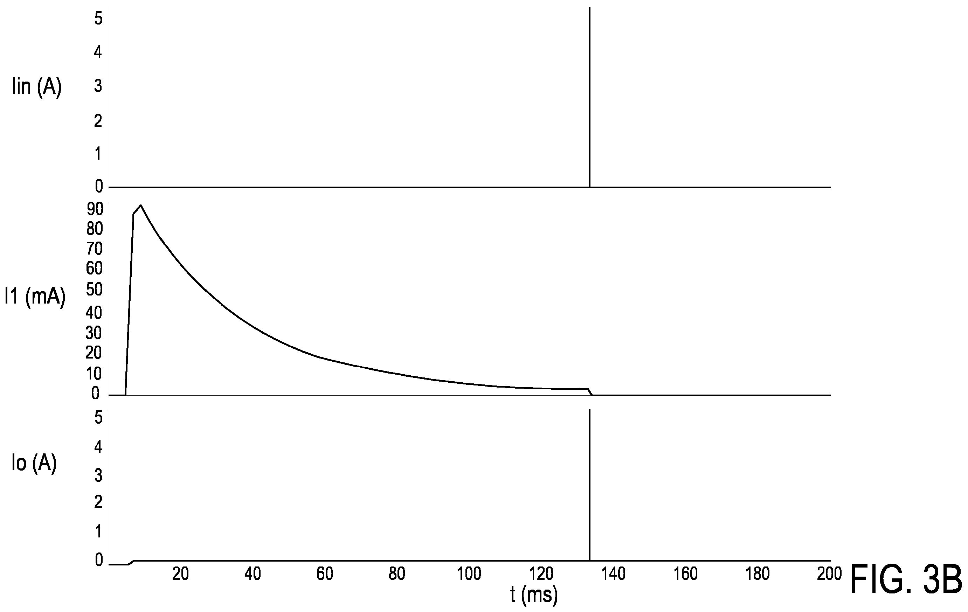

Please refer to FIG. 1, FIG. 3Aand FIG. 3B. FIG. 3A and FIG. 3B exemplify the key voltage and current waveforms of the switch trigger 1 of FIG. 1 while realizing the inrush current suppression. In FIG. 3A, Vg represents the voltage at the third terminal of the first switch Q1, and Vsen represents the voltage at the third terminal of the second switch Q2. In FIG. 3B, Iin, 11 and Io represent currents flowing through the first switch Q1, the bypass resistor R1 and the output capacitor Co, respectively. As shown in FIG. 1, FIG. 3A and FIG. 3B, when the input terminal 11 starts to receive the input voltage Vin (i.e., the input voltage Vin increases), the input voltage Vin is provided to the second switch Q2 through the diode D. At this time, the second switch Q2 is in an on state, resulting in a high level of the voltage Vg at the third terminal of the first switch Q1, and the first switch Q1 is in an off state. Under this circumstance, the input voltage Vin charges the output capacitor Co through the bypass resistor R1, thereby gradually increasing the output voltage Vo across the output capacitor Co. When the output voltage Vo is lower than the threshold voltage, the first switch Q1 remains in the off state, the second switch Q2 remains in the on state, and the output capacitor Co is charged continuously to increase the output voltage Vo gradually. When the output voltage Vo reaches to the threshold voltage, the second switch Q2 turns off, the voltage Vg at the third terminal of the first switch Q1 is discharged to zero through the discharging resistor R2, and the first switch Q1 turns on. Accordingly, the input voltage Vin is provided to the output terminal 12 through the first switch Q1. It is noted that a person skilled in the art may choose resistance values of the first divider resistor R3 and the second divider resistor R4 according to practical requirements. By changing the resistance values of the first divider resistor R3 and the second divider resistor R4, the turn-off timing of the second switch Q2 is determined. Additionally, in this embodiment, the back-stage converter is not in operation, and thus the back-stage voltage V2nd is fixed at zero.

Consequently, zero-voltage turn-on for the first switch Q1 is realized, and thus the switch loss is reduced. Further, since the output voltage Vo is already at a higher level when the first switch Q1 turns on, the voltage variation is decreased and the inrush current is reduced, thereby realizing inrush current suppression.

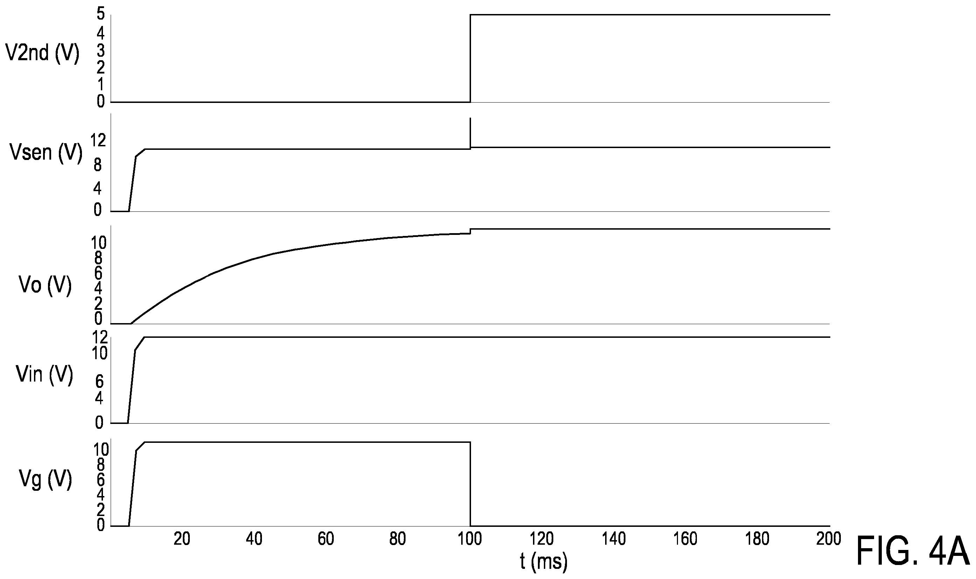

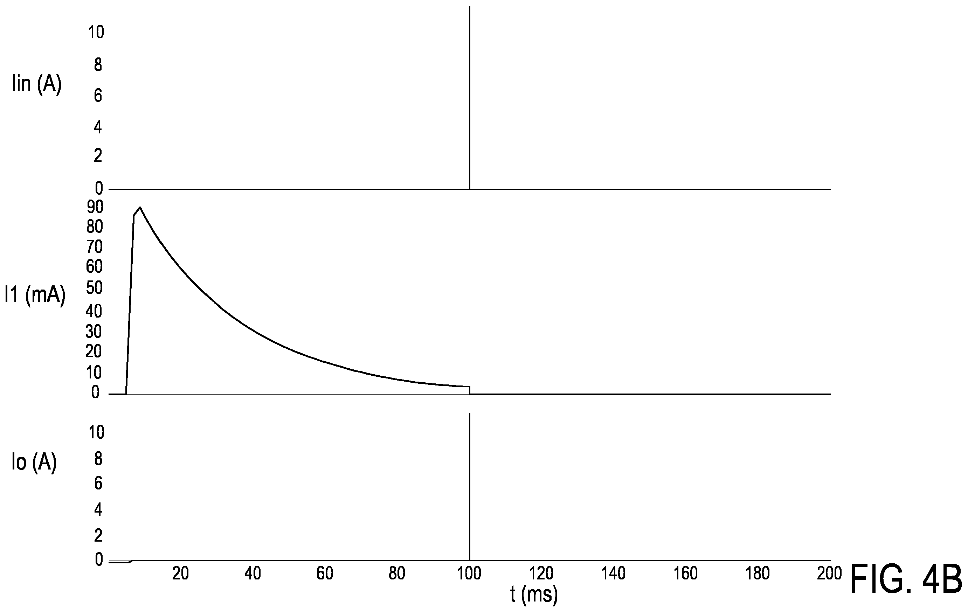

Please refer to FIG. 1, FIG. 4A and FIG. 4B. FIG. 4A and FIG. 4B exemplify the key voltage and current waveforms of the switch trigger 1 of FIG. 1 while advancing the turn-on timing of the first switch Q1 for corresponding the operation of the back-stage converter. As shown in FIG. 1, FIG. 4A and FIG. 4B, when the input terminal 11 starts to receive the input voltage Vin (i.e., the input voltage Vin increases), the second switch Q2 is in the on state, and the first switch Q1 is in the off state. Under this circumstance, the input voltage Vin charges the output capacitor Co through the bypass resistor R1, thereby gradually increasing the output voltage Vo across the output capacitor Co. When the output voltage Vo reaches to the reference voltage, the back-stage converter converts the output voltage Vo into the back-stage voltage V2nd. The back-stage voltage V2nd is transmitted to the third terminal of the second switch Q2 through the back-stage detection circuit 13, and the voltage Vsen at the third terminal of the second switch Q2 is increased by the back-stage voltage V2nd and triggers the second switch Q2 to turn off. Afterwards, the voltage Vg at the third terminal of the first switch Q1 is discharged to zero through the discharging resistor R2, and the first switch Q1 turns on. Accordingly, the input voltage Vin is provided to the output terminal 12 through the first switch Q1. The reference voltage is usually lower than the threshold voltage. Therefore, compared with the embodiment shown in FIG. 3A and FIG. 3B, in this embodiment, the turn-off timing of the second switch Q2 is advanced due to the operation of the back-stage converter, and thus the turn-on timing of the first switch Q1 is advanced as well. Electric energy is provided to the back-stage converter through the first switch Q1 such that the back-stage converter is able to operate stably. As an example, the reference voltage is equal to 80% or 90% of the input voltage Vin, but not limited thereto.

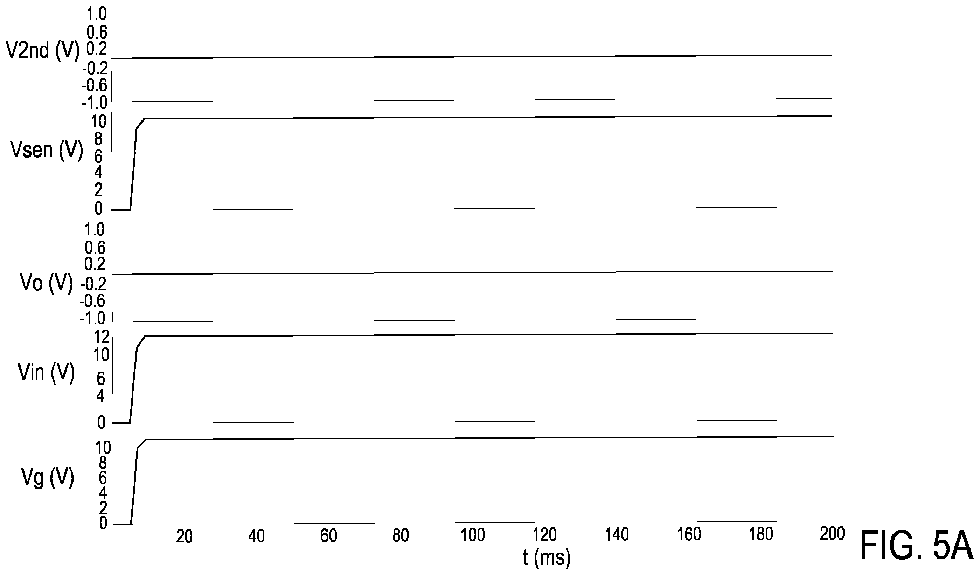

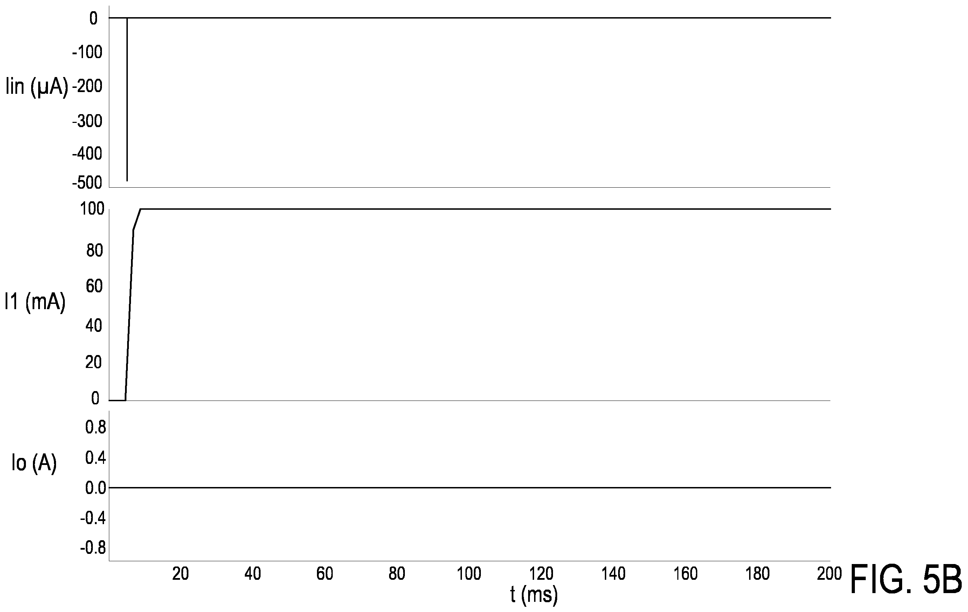

Please refer to FIG. 1, FIG. 5A and FIG. 5B. FIG. 5A and FIG. 5B exemplify the key voltage and current waveforms of the switch trigger 1 of FIG. 1 while implementing the short-circuit protection for the short circuit occurring at the output. As shown in FIG. 1, FIG. 5A and FIG. 5B, when the input terminal 11 receives the input voltage Vin and the output terminal 12 is short-circuited to the ground terminal, the output voltage Vo becomes zero, the second switch Q2 remains in the on state, and the voltage Vg at the third terminal of first switch Q1 remains at the high level. As a result, the first switch Q1 remains in the off state and would not be triggered to turn on, and thus the short-circuit protection is achieved.

In summary, the present disclosure provides a switch trigger which reduces the voltage variation while turning on the switch by precharge, thereby suppressing the inrush current. Consequently, the problems like efficiency reduction, switch damage, and the inability to turn off the switch immediately while triggering the protection, which are caused by the increased time for switching the switch in conventional approach, are avoided. Moreover, in the present disclosure, the switch trigger is able to realize zero-voltage switching and has the function of short circuit protection. Further, the switch trigger can ensure the stable output of the back-stage converter.

## Claims

1. A switch trigger (1) comprising:
an input terminal (11) and an output terminal (12);
a first switch (Q1) having a first terminal and a second terminal respectively and electrically connected to the input terminal (11) and the output terminal (12);
a bypass resistor (R1) having two terminals respectively and electrically connected to the input terminal (11) and the output terminal (12);
an output capacitor (Co) having two terminals respectively and electrically connected to the output terminal (12) and a ground terminal;
a diode (D) having an anode electrically connected to the input terminal (11);
a second switch (Q2) having a first terminal and a second terminal respectively and electrically connected to a cathode of the diode (D) and a control terminal of the first switch (Q1);
a discharging resistor (R2) having two terminals respectively and electrically connected to the control terminal of the first switch (Q1) and the ground terminal; and
a first divider resistor (R3) and a second divider resistor (R4), electrically connected in series between the output terminal (12) and the ground terminal, wherein a connection node between the first divider resistor (R3) and the second divider resistor (R4) is electrically connected to a control terminal of the second switch (Q2).

2. The switch trigger (1) according to claim 1, wherein, when the input terminal (11) receives an input voltage (Vin), the first switch (Q1) is in an off state, the second switch (Q2) is in an on state, the input voltage (Vin) charges the output capacitor (Co) through the bypass resistor (R1) for increasing an output voltage (Vo) across the output capacitor (Co).

3. The switch trigger (1) according to claim 2, wherein, when the output voltage (Vo) increases to reach to a threshold voltage, the second switch (Q2) turns off, a voltage (Vg) at the control terminal of the first switch (Q1) is discharged to zero through the discharging resistor (R2) so that the first switch (Q1) turns on, and the input voltage (Vin) is provided to the output terminal (12) through the first switch (Q1).

4. The switch trigger (1) according to claim 1, further comprising a back-stage detection circuit (13) which comprises:
a detection terminal (14) electrically connected to a back-stage voltage (V2nd), wherein the output terminal (12) is electrically connected to a back-stage voltage converter, and the back-stage voltage converter is configured to convert an output voltage (Vo) provided by the output terminal (12) into the back-stage voltage (V2nd);
a detection capacitor (C1) having two terminals respectively and electrically connected to the control terminal of the second switch (Q2) and the detection terminal (14); and
a detection resistor (R5) having two terminals respectively and electrically connected to the detection terminal (14) and the ground terminal.

5. The switch trigger (1) according to claim 4, wherein, when the input terminal (11) receives an input voltage (Vin), the first switch (Q1) is in an off state, the second switch (Q2) is in an on state, the input voltage (Vin) charges the output capacitor (Co) through the bypass resistor (R1) for increasing the output voltage (Vo) across the output capacitor (Co).

6. The switch trigger (1) according to claim 5, wherein, when the output voltage (Vo) increases to reach to a reference voltage, the back-stage voltage converter converts the output voltage (Vo) into the back-stage voltage (V2nd), the back-stage voltage (V2nd) triggers the second switch (Q2) to turn off through the back-stage detection circuit (13), a voltage (Vg) at the control terminal of the first switch (Q1) is discharged to zero through the discharging resistor (R2) so that the first switch (Q1) turns on, and the input voltage (Vin) is provided to the output terminal (12) through the first switch (Q1).

7. The switch trigger (1) according to claim 6, wherein the reference voltage is equal to 80% or 90% of the input voltage (Vin).

8. The switch trigger (1) according to claim 5, wherein the back-stage voltage (V2nd) generates an instant voltage across the detection capacitor (C1), and the instant voltage changes a voltage (Vsen) at the control terminal of the second switch (Q2) so that a turn-off timing of the second switch (Q2) is advanced, which advances a turn-on timing of the first switch (Q1).

9. The switch trigger (1) according to claim 1, wherein resistance values of the first divider resistor (R3) and the second divider resistor (R4) are selectable and are utilized to determine a turn-off timing of the second switch (Q2).

10. The switch trigger (1) according to claim 1, wherein the first switch (Q1) is a P-type metal-oxide-semiconductor field effect transistor, and the first terminal, the second terminal and the control terminal of the first switch (Q1) are a source, a drain and a gate, respectively.

11. The switch trigger (1) according to claim 1, wherein the second switch (Q2) is a bipolar junction transistor, and the first terminal, the second terminal and the control terminal of the second switch (Q2) are an emitter, a collector and a base, respectively.

12. The switch trigger (1) according to claim 1, wherein the second switch (Q3) is a P-type metal-oxide-semiconductor field effect transistor, and the first terminal, the second terminal and the control terminal of the second switch (Q3) are a source, a drain and a gate, respectively.

13. The switch trigger (1) according to claim 1, further comprising an input capacitor (Cin), wherein two terminals of the input capacitor (Cin) are respectively and electrically connected to the input terminal (11) and the ground terminal, and the input capacitor (Cin) is configured for decoupling.

14. The switch trigger (1) according to claim 1, wherein, when the input terminal (11) receives an input voltage (Vin) and the output terminal (12) is short-circuited to the ground terminal, an output voltage (Vo) across the output capacitor (Co) becomes zero, the second switch (Q2) remains in an on state, a voltage (Vg) at the control terminal of the first switch (Q1) remains at a high level, and the first switch (Q1) remains in an off state.

## Patentansprüche

1. Schalterauslöser (1), umfassend:
einen Eingangsanschluss (11) und einen Ausgangsanschluss (12);
einen ersten Schalter (Q1) mit einem ersten Anschluss und einem zweiten Anschluss, die mit dem Eingangsanschluss (11) bzw. mit dem Ausgangsanschluss (12) elektrisch verbunden sind;
einen Bypass-Widerstand (R1) mit zwei Anschlüssen, die mit dem Eingangsanschluss (11) bzw. mit dem Ausgangsanschluss (12) elektrisch verbunden sind;
einen Ausgangskondensator (Co) mit zwei Anschlüssen, die mit dem Ausgangsanschluss (12) bzw. mit einem Masseanschluss elektrisch verbunden sind;
eine Diode (D) mit einer Anode, die elektrisch mit dem Eingangsanschluss (11) verbunden ist;
einen zweiten Schalter (Q2) mit einem ersten Anschluss und einem zweiten Anschluss, die mit einer Kathode der Diode (D) bzw. mit einem Steueranschluss des ersten Schalters (Q1) elektrisch verbunden sind;
einen Entladewiderstand (R2) mit zwei Anschlüssen, die mit dem Steueranschluss des ersten Schalters (Q1) bzw. mit dem Masseanschluss elektrisch verbunden sind; und
einen ersten Teilerwiderstand (R3) und einen zweiten Teilerwiderstand (R4), die in Reihe zwischen dem Ausgangsanschluss (12) bzw. mit dem Masseanschluss elektrisch verbunden sind, wobei ein Verbindungsknoten zwischen dem ersten Teilerwiderstand (R3) und dem zweiten Teilerwiderstand (R4) mit einem Steueranschluss des zweiten Schalters (Q2) elektrisch verbunden ist.

2. Schalterauslöser (1) nach Anspruch 1, wobei, wenn der Eingangsanschluss (11) eine Eingangsspannung (Vin) empfängt, sich der erste Schalter (Q1) in einem Aus-Zustand befindet, sich der zweite Schalter (Q2) in einem Ein-Zustand befindet, die Eingangsspannung (Vin) den Ausgangskondensator (Co) über den Bypass-Widerstand (R1) auflädt, um eine Ausgangsspannung (Vo) über dem Ausgangskondensator (Co) zu erhöhen.

3. Schalterauslöser (1) nach Anspruch 2, wobei, wenn die Ausgangsspannung (Vo) ansteigt, um eine Grenzwertspannung zu erreichen, der zweite Schalter (Q2) ausgeschaltet wird, eine Spannung (Vg) an dem Steueranschluss des ersten Schalters (Q1) über den Entladewiderstand (R2) auf Null entladen wird, so dass der erste Schalter (Q1) eingeschaltet wird, und die Eingangsspannung (Vin) über den ersten Schalter (Q1) an den Ausgangsanschluss (12) angelegt wird.

4. Schalterauslöser (1) nach Anspruch 1, außerdem mit einer Backstage-Detektionsschaltung (13), umfassend:
einen Detektionsanschluss (14), der mit einer Backstage-Spannung (V2nd) elektrisch verbunden ist, wobei der Ausgangsanschluss (12) mit einem Backstage-Spannungswandler elektrisch verbunden ist, und der Backstage-Spannungswandler ausgestaltet ist, um eine von dem Ausgangsanschluss (12) zur Verfügung gestellte Ausgangsspannung (Vo) in die Backstage-Spannung (V2nd) umzuwandeln;
einen Detektionskondensator (C1) mit zwei Anschlüssen, die mit dem Steueranschluss des zweiten Schalters (Q2) bzw. mit dem Detektionsanschluss (14) elektrisch verbunden sind; und
einen Detektionswiderstand (R5) mit zwei Anschlüssen, die mit dem Detektionsanschluss (14) bzw. mit dem Masseanschluss elektrisch verbunden sind.

5. Schalterauslöser (1) nach Anspruch 4, wobei, wenn der Eingangsanschluss (11) eine Eingangsspannung (Vin) empfängt, sich der erste Schalter (Q1) in einem Aus-Zustand befindet, sich der zweite Schalter (Q2) in einem Ein-Zustand befindet, die Eingangsspannung (Vin) den Ausgangskondensator (Co) über den Bypass-Widerstand (R1) auflädt, um die Ausgangsspannung (Vo) über dem Ausgangskondensator (Co) zu erhöhen.

6. Schalterauslöser (1) nach Anspruch 5, wobei, wenn die Ausgangsspannung (Vo) ansteigt, um eine Referenzspannung zu erreichen, der Backstage-Spannungswandler die Ausgangsspannung (Vo) in die Backstage-Spannung (V2nd) umwandelt, die Backstage-Spannung (V2nd) den zweiten Schalter (Q2) über die Backstage-Detektionsschaltung (13) auslöst, um ausgeschaltet zu werden, eine Spannung (Vg) an dem Steueranschluss des ersten Schalters (Q1) über den Entladewiderstand (R2) auf Null entladen wird, so dass der erste Schalter (Q1) eingeschaltet wird, und die Eingangsspannung (Vin) über den ersten Schalter (Q1) an den Ausgangsanschluss (12) angelegt wird.

7. Schalterauslöser (1) nach Anspruch 6, wobei die Referenzspannung 80% oder 90% der Eingangsspannung (Vin) beträgt.

8. Schalterauslöser (1) nach Anspruch 5, wobei die Backstage-Spannung (V2nd) eine Momentanspannung über dem Detektionskondensator (C1) erzeugt, und die Momentanspannung eine Spannung (Vsen) an dem Steueranschluss des zweiten Schalters (Q2) verändert, so dass ein Ausschaltzeitpunkt des zweiten Schalters (Q2) vorverlegt wird, wodurch ein Einschaltzeitpunkt des ersten Schalters (Q1) vorverlegt wird.

9. Schalterauslöser (1) nach Anspruch 1, wobei die Widerstandswerte des ersten Teilerwiderstands (R3) und des zweiten Teilerwiderstands (R4) auswählbar sind und zur Bestimmung eines Ausschaltzeitpunkts des zweiten Schalters (Q2) verwendet werden.

10. Schalterauslöser (1) nach Anspruch 1, wobei der erste Schalter (Q1) ein Metalloxid-Halbleiter-Feldeffekttransistor vom P-Typ ist, und der erste Anschluss, der zweite Anschluss und der Steueranschluss des ersten Schalters (Q1) eine Source, ein Drain bzw. ein Gate sind.

11. Schalterauslöser (1) nach Anspruch 1, wobei der zweite Schalter (Q2) ein bipolarer Sperrschichttransistor ist, und der erste Anschluss, der zweite Anschluss und der Steueranschluss des zweiten Schalters (Q2) ein Emitter, ein Kollektor bzw. eine Basis sind.

12. Schalterauslöser (1) nach Anspruch 1, wobei der zweite Schalter (Q3) ein Metalloxid-Halbleiter-Feldeffekttransistor vom P-Typ ist, und der erste Anschluss, der zweite Anschluss und der Steueranschluss des zweiten Schalters (Q3) eine Source, ein Drain bzw. ein Gate sind.

13. Schalterauslöser (1) nach Anspruch 1, außerdem mit einem Eingangskondensator (Cin), wobei zwei Anschlüsse des Eingangskondensators (Cin) mit dem Eingangsanschluss (11) bzw. dem Masseanschluss elektrisch verbunden sind, und der Eingangskondensator (Cin) zum Entkoppeln konfiguriert ist.

14. Schalterauslöser (1) nach Anspruch 1, wobei, wenn der Eingangsanschluss (11) eine Eingangsspannung (Vin) empfängt und der Ausgangsanschluss (12) zum Masseanschluss kurzgeschlossen ist, eine Ausgangsspannung (Vo) über dem Ausgangskondensator (Co) Null wird, der zweite Schalter (Q2) in einem Ein-Zustand bleibt, eine Spannung (Vg) an dem Steueranschluss des ersten Schalters (Q1) auf einem hohen Pegel bleibt, und der erste Schalter (Q1) in einem Aus-Zustand bleibt.

## Revendications

1. Déclencheur de commutateur (1) comprenant:
une borne d'entrée (11) et une borne de sortie (12);
un premier interrupteur (Q1) ayant une première borne et une deuxième borne connectées respectivement et électriquement à la borne d'entrée (11) et à la borne de sortie (12);
une résistance de dérivation (R1) ayant deux bornes connectées respectivement et électriquement à la borne d'entrée (11) et à la borne de sortie (12);
un condensateur de sortie (Co) ayant deux bornes connectées respectivement et électriquement à la borne de sortie (12) et à une borne de masse;
une diode (D) ayant une anode connectée électriquement à la borne d'entrée (11);
un deuxième interrupteur (Q2) ayant une première borne et une deuxième borne connectées respectivement et électriquement à une cathode de la diode (D) et à une borne de commande du premier interrupteur (Q1);
une résistance de décharge (R2) ayant deux bornes connectées respectivement et électriquement à la borne de commande du premier interrupteur (Q1) et à la borne de masse; et
une première résistance de diviseur (R3) et une deuxième résistance de diviseur (R4), montées en série électriquement entre la borne de sortie (12) et la borne de masse, dans lequel un nœud de connexion entre la première résistance de diviseur (R3) et la deuxième résistance de diviseur (R4) est connecté électriquement à une borne de commande du deuxième interrupteur (Q2).

2. Déclencheur de commutateur (1) selon la revendication 1, dans lequel, lorsque la borne d'entrée (11) reçoit une tension d'entrée (Vin), le premier interrupteur (Q1) est dans un état bloqué, le deuxième interrupteur (Q2) est dans un état passant, la tension d'entrée (Vin) charge le condensateur de sortie (Co) à travers la résistance de dérivation (R1) pour augmenter une tension de sortie (Vo) aux bornes du condensateur de sortie (Co).

3. Déclencheur de commutateur (1) selon la revendication 2, dans lequel, lorsque la tension de sortie (Vo) augmente pour atteindre une tension de seuil, le deuxième interrupteur (Q2) devient bloqué, une tension (Vg) présente à la borne de commande du premier interrupteur (Q1) est déchargée à zéro à travers la résistance de décharge (R2), de sorte que le premier interrupteur (Q1) devient passant, et la tension d'entrée (Vin) est appliquée à la borne de sortie (12) par l'intermédiaire du premier interrupteur (Q1).

4. Déclencheur de commutateur (1) selon la revendication 1, comprenant en outre un circuit de détection d'arrière-plan (13) qui comprend:
une borne de détection (14) connectée électriquement à une tension d'arrière-plan (V2nd), dans lequel la borne de sortie (12) est connectée électriquement à un convertisseur de tension d'arrière-plan, et le convertisseur de tension d'arrière-plan est configuré pour convertir une tension de sortie (Vo) fournie par la borne de sortie (12) en ladite tension d'arrière-plan (V2nd);
un condensateur de détection (C1) ayant deux bornes connectées respectivement et électriquement à la borne de commande du deuxième interrupteur (Q2) et à la borne de détection (14); et
une résistance de détection (R5) ayant deux bornes connectées respectivement et électriquement à la borne de détection (14) et à la borne de masse.

5. Déclencheur de commutateur (1) selon la revendication 4, dans lequel, lorsque la borne d'entrée (11) reçoit une tension d'entrée (Vin), le premier interrupteur (Q1) est dans un état bloqué, le deuxième interrupteur (Q2) est dans un état passant, la tension d'entrée (Vin) charge le condensateur de sortie (Co) à travers la résistance de dérivation (R1) pour augmenter la tension de sortie (Vo) aux bornes du condensateur de sortie (Co).

6. Déclencheur de commutateur (1) selon la revendication 5, dans lequel, lorsque la tension de sortie (Vo) augmente pour atteindre une tension de référence, le convertisseur de tension d'arrière-plan convertit la tension de sortie (Vo) en ladite tension d'arrière-plan (V2nd), la tension d'arrière-plan (V2nd) déclenche le deuxième interrupteur (Q2) pour qu'il devienne bloqué par l'intermédiaire du circuit de détection d'arrière-plan (13), une tension (Vg) à la borne de commande du premier interrupteur (Q1) est déchargée à zéro à travers la résistance de décharge (R2), de sorte que le premier interrupteur (Q1) devient passant, et la tension d'entrée (Vin) est appliquée à la borne de sortie (12) par l'intermédiaire du premier interrupteur (Q1).

7. Déclencheur de commutateur (1) selon la revendication 6, dans lequel la tension de référence est égale à 80 % ou 90 % de la tension d'entrée (Vin).

8. Déclencheur de commutateur (1) selon la revendication 5, dans lequel la tension d'arrière-plan (V2nd) produit une tension instantanée aux bornes du condensateur de détection (C1), et la tension instantanée modifie une tension (Vsen) à la borne de commande du deuxième interrupteur (Q2) de telle manière qu'un minutage de blocage du deuxième interrupteur (Q2) est avancé, ce qui avance un minutage de déblocage du premier interrupteur (Q1).

9. Déclencheur de commutateur (1) selon la revendication 1, dans lequel les valeurs de résistance de la première résistance de diviseur (R3) et de la deuxième résistance de diviseur (R4) peuvent être sélectionnées et sont utilisées pour déterminer un minutage de blocage du deuxième interrupteur (Q2).

10. Déclencheur de commutateur (1) selon la revendication 1, dans lequel le premier interrupteur (Q1) est un transistor à effet de champ métal-oxyde-semiconducteur de type P, et la première borne, la deuxième borne et la borne de commande du premier interrupteur (Q1) sont respectivement une source, un drain et une grille.

11. Déclencheur de commutateur (1) selon la revendication 1, dans lequel le deuxième interrupteur (Q2) est un transistor bipolaire à jonctions, et la première borne, la deuxième borne et la borne de commande du deuxième interrupteur (Q2) sont respectivement un émetteur, un collecteur et une base.

12. Déclencheur de commutateur (1) selon la revendication 1, dans lequel le deuxième interrupteur (Q3) est un transistor à effet de champ métal-oxyde-semiconducteur de type P, et la première borne, la deuxième borne et la borne de commande du deuxième interrupteur (Q3) sont respectivement une source, un drain et une grille.

13. Déclencheur de commutateur (1) selon la revendication 1, comprenant en outre un condensateur d'entrée (Cin), dans lequel deux bornes du condensateur d'entrée (Cin) sont connectées respectivement et électriquement à la borne d'entrée (11) et à la borne de masse, et le condensateur d'entrée (Cin) est configuré pour réaliser un découplage.

14. Déclencheur de commutateur (1) selon la revendication 1, dans lequel, lorsque la borne d'entrée (11) reçoit une tension d'entrée (Vin) et que la borne de sortie (12) est mise en court-circuit avec la borne de masse, une tension de sortie (Vo) aux bornes du condensateur de sortie (Co) devient nulle, le deuxième interrupteur (Q2) reste dans un état passant, une tension (Vg) à la borne de commande du premier interrupteur (Q1) reste à un niveau haut, et le premier interrupteur (Q1) reste dans un état bloqué.
